Europäisches Patentamt

European Patent Office

Office européen des brevets

(11) Numéro de publication: **0 278 836**
**A2**

# (12) DEMANDE DE BREVET EUROPEEN

(21) Numéro de dépôt: **88400179.3**

(22) Date de dépôt: **27.01.88**

(51) Int. Cl.⁴: **C 03 C 17/23**

(30) Priorité: **27.01.87 JP 16387/87**

(43) Date de publication de la demande:
**17.08.88 Bulletin 88/33**

(84) Etats contractants désignés:
**AT BE CH DE ES FR GB IT LI LU NL SE**

(71) Demandeur: **SAINT-GOBAIN VITRAGE**
**Les Miroirs 18, avenue d'Alsace**
**F-92400 Courbevoie (FR)**

(72) Inventeur: **Hirata, Masahiro**
**21-1-320, Ohata-cho**
**Takatsuki-shi Osaka (JP)**

**Misonou, Masao**
**6-1-104, Damjo-cho 6-chome**
**Nishinomiya-shi Hyogo (JP)**

**Kawahara, Hideo**
**8-3-205, Minami Sakurazuka 2-chome**
**Toyonaka-shi Osaka (JP)**

(74) Mandataire: **Leconte, Jean-Gérard et al**
**Saint-Gobain Recherche 39, Quai Lucien Lefranc**
**F-93304 Aubervilliers Cedex (FR)**

(54) Fabrication d'un conducteur électrique transparent.

(57) L'invention concerne la fabrication de conducteurs électriques transparents.

Elle propose pour améliorer la conduction électrique des couches minces électroconductrices déposées par exemple sur un substrat en verre, de les soumettre à un traitement thermique après dépôt.

L'invention est applicable sur des couches à base d'oxyde d'étain déposés par CVD.

EP 0 278 836 A2

**Description**

## FABRICATION D'UN CONDUCTEUR ELECTRIQUE TRANSPARENT

La présente invention concerne la fabrication d'un conducteur électrique transparent de faible résistance électrique et de haute transparence.

Plus précisément elle porte sur la fabrication d'un conducteur électrique transparent constitué d'un substrat comportant une couche électroconductrice transparente composée principalement d'oxyde d'étain.

De tels conducteurs électriques transparents sont utilisés dans des piles solaires, ou constituent des électrodes transparentes dans des éléments d'affichage à cristaux liquides, des éléments électroluminescents, des surfaces chauffantes, etc...

Il est connu de constituer des couches conductrices par exemple déposées sur des substrats en verre ; ces couches sont par exemple à base d'oxyde d'étain dopé au fluor ou à l'antimoine, à base d'oxyde d'indium dopé à l'étain (ITO).

Ces couches sont obtenues par pyrolyse de composés liquides, pulvérulents ou gazeux, ou encore par des techniques sous vide : évaporation, pulvérisation cathodique magnétron etc...

Les couches pyrolysées, en particulier celles à base d'oxyde d'étain présentent l'avantage d'être particulièrement résistantes aux attaques chimiques, d'avoir une bonne résistance mécanique et de permettre l'emploi de matières premières relativement bon marché.

Par contre leur résistance électrique est assez élevée, ce qui constitue une gêne pour les applications envisagées.

La présente invention vise à résoudre ce problème de la résistance électrique trop élevée des couches minces pyrolysées en fournissant un nouveau procédé pour les fabriquer.

Elle propose pour cela un procédé de fabrication consistant à procéder à un traitement thermique des couches après leur dépôt sur un substrat, notamment en verre, par les techniques de pyrolyse classiques.

L'invention s'applique plus particulièrement aux couches à base d'oxyde d'étain.

Le traitement thermique s'effectue sur une couche brute de dépôt, c'est à dire sans aucun traitement après dépôt.

Ainsi donc, une couche mince composée essentiellement d'oxyde d'étain est déposée sur un support transparent notamment en verre. Pour cela une composition comportant au moins un composé d'étain et un dopant, notamment le fluor est mise en contact avec le support chauffé à haute température.

Au contact du support chaud, la composition se décompose et s'oxyde pour former la couche mince d'oxyde d'étain.

Selon cette invention, comme composé d'étain on peut utiliser $C_4H_9$ Sn, $Sn Cl_4$, $(CH_3)$ Sn $(Cl_2$, $(C_nH_{2n+1})_4$ Sn où n = 1,2,3 ou 4, $(CH_3)_2$ Sn $H_2$, $C_4H_9)_3$ SnH, $(C_4H_9)_2$ Sn $(COOCH_3)_2$ etc...

Comme dopant fluoré on peut employer $CH_3CHF_2$, $CH_3 CClF_2$, $CHClF_2$, $CHF_3$, $CF_2Cl_2$, $CF_3Cl$, $CF_3Br$, etc...

On peut également employer d'autres composés, par exemple des composés dont les molécules contiennent à la fois de l'étain et du fluor.

Pour pyrolyser la composition mise en contact avec le substrat transparent chauffé on peut utiliser différentes méthodes connues, mais on préférera la méthode dite CVD (chemical vapour deposition) par laquelle on met la composition contenant de l'étain et du fluor, sous forme de vapeur, en contact avec le substrat chauffé à une température de l'ordre de 400 à 650°C. On obtient ainsi sur le substrat une couche mince d'oxyde d'étain dopé au fluor.

Selon l'invention, après dépôt on pratique un traitement thermique de la couche obtenue sous une pression normale ou réduite, en atmosphère de préférence neutre ou réductrice, par exemple sous atmosphère de $H_2$ ou de $N_2$ ou encore sous un mélange $H_2 + N_2$. Ce traitement peut encore se faire sous vide. Ce traitement thermique s'effectue à une température inférieure à celle du dépôt de la couche électroconductrice, à savoir à une température inférieure à 400°C. De préférence la température de traitement s'échelonne entre 250 et 350°C. Par ce traitement, la surface de la couche électroconductrice est légèrement réduite et la conduction électrique s'en trouve améliorée.

L'invention sera maintenant expliquée à l'aide d'exemples non limitatifs.

Exemple 1

Comme support transparent on utilise des plaques de verre so docalcique et on les revêt d'une couche d'oxyde d'étain. Ces plaques de verre ont 1,1 mm d'épaisseur et leur taille est 25 mm x 30 mm. Avant revêtement elles sont parfaitement lavées et séchées.

Comme composition de revêtement on utilise un mélange gazeux de tétrachlorure, d'étain, de vapeur d'eau, d'oxygène, de 1-1 difluoroéthane, d'azote. On obtient ainsi sur les plaques de verre une couche de $SnO_2$ : F (oxyde d'étain dopé F). Pour réaliser le dépôt on utilise la méthode CVD. Le verre est chauffé à 550° avant dépôt.

On réalise ainsi plusieurs échantillons revêtus d'une couche de 2 000 angstroems, de résistance par carré de 25 ohms ($R_0$).

On effectue des traitements thermiques selon l'invention sur ces échantillons en variant la pression de l'atmosphère dans laquelle est effectué ledit traitement. Le traitement s'effectue sur la couche déposée n'ayant subi aucun autre traitement en particulier thermique. Le traitement se fait à 300°C pendant 30 minutes

en atmosphère $H_2$. Ensuite on mesure la résistance $R_1/R_0$.

Les résultats obtenus sont notés sur le tableau 1 disposé en fin de description. On constate d'après ce tableau que la résistance électrique des couches est abaissée par le traitement thermique. Par ailleurs on a constaté que la transmission lumineuse du substrat revêtu restait identique avant traitement et après traitement.

Example 2

Comme dans l'exemple 1, on a disposé une couche de $SnO_2$ : F sur des supports transparents et on a obtenu des échantillons. L'épaisseur des couches sur les échantillons est de 2000 angstroems et la résistance électrique par carré $R_0$ est de 25 ohms.

En changeant la température, on a effectué la traitement thermique des échantillons sous une pression de 124 pa pendant 10 minutes dans une atmosphère de $N_2$. Puis, on a mesuré la résistance électrique par carré (R2) des échantillons ainsi traités à des températures variant d'un échantillon à l'autre. On a établi le ratio $R_2/R_0$.

Les résultats obtenus sont indiqués au tableau 2 disposé en fin de description. Comme il est clair d'après le tableau, par le traitement thermique on peut réduire la résistance électrique de la couche $SnO_2$:F et la résistance obtenue est la plus basse pour des température de traitement de l'ordre de 250 à 350°C. D'autre part, on n'a observé aucun changement de la transmission avant et après le traitement thermique.

Example 3

Comme dans les exemples 1 et 2, on a déposé une couche de $SnO_2$:F sur des verres et obtenu des échantillons. L'épaisseur de la couche sur les échantillons est de 2000 angestroems et la résistance carré (Ro) de 25 ohms.

En changeant la pression d'un échantillons à l'autre, on a effectué des traitements thermiques à 300°C pendant 10 minutes dans une atmosphère de $H_2$. Puis, on a mesuré la résistance carré (R3) des échantillons ainsi traités sous différentes pressions et on a obtenu le ratio R3/Ro.

Les résultats obtenus, sont indiqués au tableau 3 disposé en fin de description. Comme il est clair d'après le tableau, par le traitement thermique sous une pression réduite, on peut réduire la résistance électrique de la couche $SnO_2$:F. D'autre part, on n'a observé aucun changement de la transmission avant et après le traitement thermique.

Exemple 4

Comme dans les exemples précédents, on a déposé une couche de $SnO_2$:F sur des verres et obtenu des échantillons. L'épaisseur de couche des échantillons est de 2000 angostroems de la résistance électrique (Ro) est de 25 ohms.

En changeant la température d'un échantillon à l'autre, on a effectué des traitements thermiques sous une pression de 33 Pa pedant 10 minutes dans une atmosphère de $H_2$. Puis, on a mesuré la résistance électrique (R4) des échantillons ainsi traités et obtenu le ratio R4/Ro.

Les résultats obtenus sont indiqués au tableau 4 disposé en fin de description. Comme il est clair d'après le tableau, par le traitement thermique, on peut réduire la résistance électrique de la couche de $SnO_2$:F. D'autre part, on n'a observé aucun changement de la transmission avant et après le traitement thermique. Les résistances les plus basses sont obtenues pour les traitements à température comprise entre 200 et 300°C.

Exemple 5

Comme dans l'exemple 1, on a deposé une couche de $SnO_2$:F sur des verres et obtenu des échantillons. L'épaisseur de couche des échantillons est de 2000 angstroems et la résistance électrique de 25 ohms. On a effectué le traitement thermique à 320°C sous un vide de $1.76 \times 10^{-3}$ Pa pendant 100 minutes. La résistance électrique après le traitement thermique était de 21.6 ohms. Il est clair que, par le traitement thermiqué, la résistance superficielle de la couche de $SnO_2$:F a diminué. On n'a observé aucun changement de la transmission avant et après le traitement thermique.

Donc selon la présente invention, en faisant le traitement thermique de la couche électroconductrice transparente, on peut obtenir un conducteur électrique transparent d'une faible résistance superficielle et d'une haute transparence.

3

TABLEAU 1

| Echantillons | Pression (Pa) | R1/Ro |
|---|---|---|
| 1 | 36 | 0.91 |
| 2 | 124 | 0.86 |
| 3 | 309 | 0.86 |
| 4 | Pression normale | 0.88 |

TABLEAU 2

| Echantillons | Température (c°) | R2/Ro |
|---|---|---|
| 5 | 200 | 0.96 |
| 6 | 250 | 0.96 |
| 7 | 300 | 0.88 |
| 8 | 350 | 0.88 |
| 9 | 400 | 1.00 |

4

0 278 836

TABLEAU 3

| Echantillons | Pression (Pa) | R2/Ro |
|---|---|---|
| 10 | 13 | 0.92 |
| 11 | 33 | 0.92 |
| 12 | 80 | 0.95 |
| 13 | Pression normale | 1.02 |

TABLEAU 4

| Echantillons | Température (°C) | R4/Ro |
|---|---|---|
| 14 | 200 | 0.98 |
| 15 | 250 | 0.95 |
| 16 | 300 | 0.90 |
| 17 | 350 | 0.90 |
| 18 | 400 | 0.96 |

**Revendications**

1. Procédé de fabrication d'un conducteur électrique transparent par dépôt d'une couche mince électroconductrice sur un substrat transparent, notamment en verre, obtenue par décomposition thermique et oxydation de composés métalliques mis en contact avec le substrat, caractérisé en ce qu'on réalise le dépôt et soumet la couche à un traitement thermique.

2. Procédé selon la revendication 1, caractérisé en ce qu'on réalise le traitement thermique sur la couche brute de dépôt.

3. Procédé selon l'une des revendications 1 ou 2 caractérisé en ce que le traitement thermique s'effectue sous une pression normale ou réduite

4. Procédé selon l'une des revendications 1 à 3 caractérisé en ce que le traitement thermique s'effectue sous atmosphère de $H_2$ $N_2$ ou $H_2 + N_2$.

5. Procédé selon l'une des revendications 1 à 4 caractérisé en ce que le traitement thermique s'effectue à une température inférieure à la température de dépôt de la couche électroconductrice.

5

**0 278 836**

6. Procédé selon l'une des revendications 1 à 5 caractérisé en ce que la température de traitement est inférieure à 400°C et de préférence comprise entre 250 et 350°C.

7. Procédé selon l'une des revendications 1 à 6 caractérisé en ce que la couche est déposée par une méthode de pyrolyse liquide, gaz ou solide, mais de préférence gaz (CVD).

8. Procédé selon l'une des revendications 1 à 7 caractérisé en ce que la couche est à base d'oxyde d'étain, notamment d'oxyde d'étain dopé fluor.